# EUROPEAN PATENT APPLICATION

(11) **EP 2 557 904 A1**
(43) Date of publication of application: **13.02.2013**
(21) Application number: 11177272.9
(22) Date of filing: 11.08.2011
(51) Int. Cl.: H05K 1/02, H05K 3/18, H05K 3/32

(54) **Three-dimensionally molded electronic substrate**

(71) Applicant: Research In Motion Limited, Waterloo, ON N2L 3W8 (CA)
(72) Inventor: Holverson, Erik Alan, Hoffman Estates, IL Illinois 60192 (US); Finney, Benjamin Michael, Rolling Meadows, IL Illinois 60008 (US); Balk, Cody Allen, Rolling Meadows, IL Illinois 60008 (US)
(74) Representative: Finnie, Peter John

(57) **Abstract**

A device, system and process for fabricating a three-dimensional electronic substrate (200) are disclosed. A substrate may be molded in three-dimensions to fit the form factor of an exterior device frame. Electronics (230) and conductors (220) may be placed onto the three-dimensional surface of the molded substrate, thereby creating a three-dimensional electronic substrate. The three dimensional substrate may then be connected to an exterior frame to allow for electronic functionalities across frame form factors.

## Description

### TECHNICAL FIELD

The present disclosure relates generally to the field of three-dimensional electronic substrates.

### BACKGROUND

The growth of mobile communication has resulted in greater demand from consumers for more portable communication devices that are configured with higher levels of functionality. A necessary consequence of this trend is the need for applying electronic modules into more geometrically constraining mechanical assemblies and cover frames. For example, thinner mobile communication devices may require electronic modules to be placed at sharp angles or along non-planar surfaces.

### BRIEF DESCRIPTION OF THE DRAWINGS

FIG. 1 is an illustration showing aspects of an example of a mobile communication device that is designed with three-dimensionally molded electronic substrates.

FIG. 2 is a schematic diagram showing aspects of an example of a three-dimensionally molded electronic substrate.

FIG. 3A is a schematic diagram showing aspects of an example of a three-dimensionally molded electronic substrate attached to a frame.

FIG. 3B is a second schematic diagram showing aspects of an example of a three-dimensionally molded electronic substrate attached to a frame.

FIG. 4 is a schematic diagram showing aspects of an example of a three-dimensionally molded electronic substrate attached to a frame and a printed circuit board.

FIG. 5 is a flow chart showing aspects of a manufacturing process for fabricating a three-dimensionally molded electronic substrate.

Like reference numbers and designations in the various drawings indicate like elements.

### DESCRIPTION OF EXAMPLE EMBODIMENTS

### OVERVIEW

In some aspects, an electronic device in three dimensions includes a substrate. The substrate is molded as a three-dimensional structure that comprises at least two intersecting planes and is enabled to accept a conductive material. An overlaid conductive pattern, which comprises of the conductive material, is provided onto the three-dimensional structure so as to form a continuous pattern over at least two intersecting surface planes of the three-dimensional structure. An electronic module, comprising an electronic component and a conductive interface to the electronic component, is provided onto the three-dimensional substrate surface so as to establish electrical contact between the conductive interface and the conductive pattern.

Implementations of these and other aspects may include one or more of the following features. The three-dimensional structure includes a mechanical connection location that allows for mechanical fixation of the substrate to a frame. The overlaid conductive pattern is formed through plating. The electronic component is one of a switch, a speaker, a light emitting diode, a plug and/or an image capture device.

Additionally or alternatively, implementations of these and other aspects may include one or more of the following features. The electronic module is attached to a single plane of the three-dimensional structure. The conductive pattern comprises at least one metal layer. The molded substrate is enabled to be used in a laser direct structuring (LDS) process.

In some aspects, an electronic system configured in three-dimensions includes a frame. A substrate, molded as a three-dimensional structure that comprises at least two intersecting planes and is enabled to accept a conductive material, is connected to the frame. An overlaid conductive pattern, which comprises of the conductive material, is provided onto the three-dimensional structure so as to form a continuous pattern over at least two intersecting surface planes of the three-dimensional structure. An electronic module, comprising an electronic component and a conductive interface to the electronic component, is provided onto the three-dimensional substrate surface so as to establish electrical contact between the conductive interface and the conductive pattern. A circuit board is electrically connected to the overlaid conductive pattern.

Implementations of these and other aspects may include one or more of the following features. The frame includes at least one mechanical structure that is configured to accommodate a mechanical connection. The three-dimensional structure includes a mechanical receiving location that allows for mechanical fixation of the substrate to the frame through the frame's mechanical connection structure. The overlaid conductive pattern is formed through plating. The electronic component is one of a switch, a speaker, a light emitting diode, a plug and/or an image capture device.

Additionally or alternatively, implementations of these and other aspects may include one or more of the following features. The electronic module is attached to a single plane of the three-dimensional structure. The conductive pattern comprises at least one metal layer. The molded substrate is enabled to be used in a laser direct structuring (LDS) process. The circuit board includes a metallic spring contact that is configured to make an electrical contact with the overlaid conductive pattern. The circuit board is mechanically connected to the frame. The frame comprises a molded material. The frame includes conductive patterns.

In some aspects, a manufacturing process includes molding a substrate into a three-dimensional structure that comprises at least two intersecting planes. The molded substrate is activated in selective regions including a continuous pattern over at least two intersecting surface planes of the three-dimensional structure. A conductor is deposited onto the selectively activated regions. An electronic module, comprising an electronic component and a conductive interface to the electronic component, is attached to the three-dimensional structure so as to establish electrical contact between the conductive interface and the conductive pattern.

Details of one or more implementations are set forth in the accompanying drawings and the description herein. Other features and aspects will be apparent from the description, the drawings, and the claims.

### DETAILED DESCRIPTION

In a mobile device, there are a number of electronic components, such as switches, speakers, LEDs, and/or input/output (I/O) plugs that are provided externally from the mobile device's external frame. Depending on the size and shape of the mobile device, the electronic modules that package these electronic components are connected directly to either a rigid printed circuit board (PCB) or to a flexible circuit board (Flex).

The current approaches of using PCB and Flex may greatly limit the form factors that can be realized for fabricating a mobile device. In particular, electronic modules that are connected to PCBs may be limited to a two dimensional structure. As a result, the use of these electronic modules is restricted to a limited number of frame form factors that can accommodate the PCB's geometry.

Flex suffers from a different set of form factor issues. These issues are mainly associated with the reliability of electrical connections for electronic modules, especially in regions which have experienced deformations. Thus, the form factors of the frames need to be designed to provide additional support to accommodate Flex in a manner that can prevent reliability problems with the connected electronic modules.

In order to create more flexible architectures, the present disclosure describes the use of a three dimensionally molded plastic substrate on which electronic modules may be mounted. The molded plastic substrate has conductive tracks patterned onto it and to which the mounted electronic modules are electrically connected. Because of the freedom allowed for molding the plastic substrate, a PCB or Flex circuit may be electrically connected to the patterned tracks on the molded plastic substrate without imposing form factor requirements for the external frame. As a result, a larger number of form factors may be realized for the external frame of a mobile device, thereby greatly increasing the aesthetics and user experience tied with the device.

The term "comprising" and variations thereof as used herein are used synonymously with the term "including" and variations thereof and are open, nonlimiting terms.

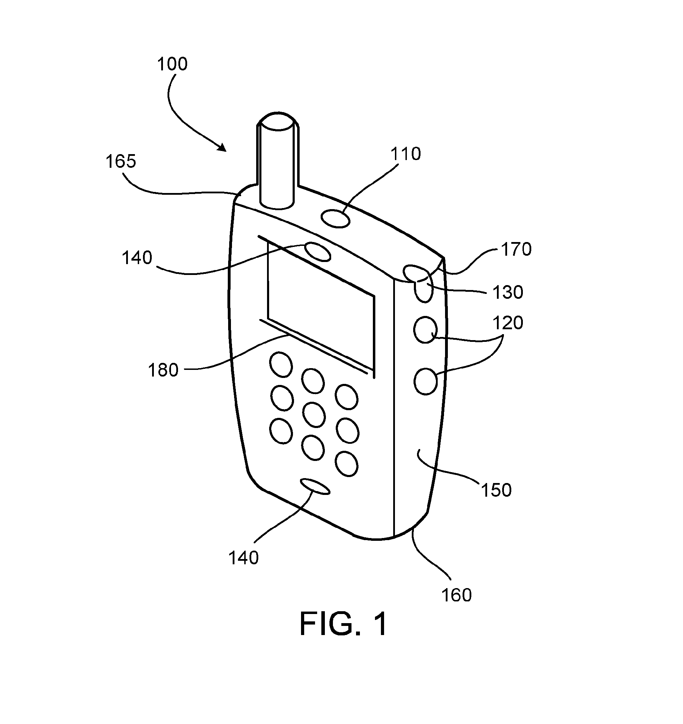

FIG. 1 shows an exemplary system 100 of a mobile communication device that is designed with a plurality of three-dimensionally molded electronic substrates 110, 120, 130 and 140. The mobile communication device consists of an external frame 150 which covers the internal device electronics. The frame 150 may include a single molded piece, or may comprise a plurality of subassembly pieces that may be mechanically interlocked or fused together. The frame 150 may be designed to include any number of physical features, such as radii of curvatures 160 and 165, abrupt edges separating two planes 170 and surface topologies 180.

In order to accommodate for these structural variations in frame 150, three-dimensionally molded electronic substrates may be designed to be adapted around these features. For example, three-dimensionally molded electronic substrate 110 may be molded so as to conform around radius of curvature 165 and three-dimensionally molded electronic substrates 120 may be molded so as to conform around radius of curvature 160. In addition, the three-dimensionally molded electronic substrate 130 may be molded so as to conform around abrupt edge 170 and radius of curvature 160 and 165.

Because the three-dimensionally molded electronic substrate may be designed around a large variety of form factors, it may interface with frame 150 from the frame's inner walls (i.e. laying inside frame 150), and/or from the frame's outer wall (i.e. laying outside frame 150), and/or from the frame's inner and outer wall (i.e. laying both inside and outside frame 150). In addition, the three-dimensionally molded electronic substrate may be formed in a manner such as to allow various forms to protrude or depress into the frame. Such features may be advantageous for the mobile communication device's user experience and/or aesthetics.

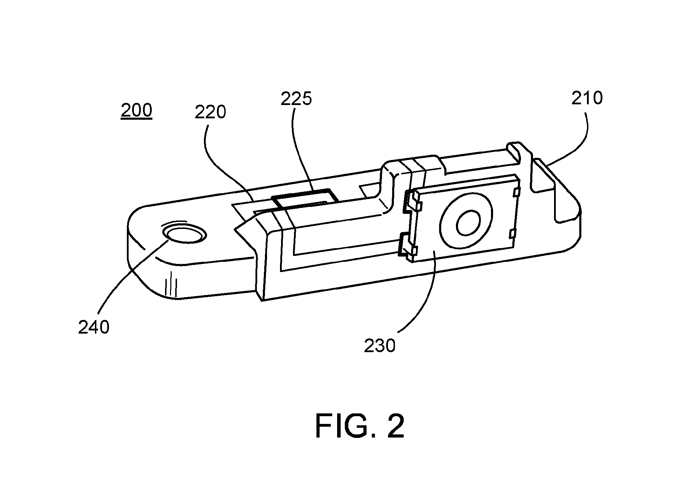

Reference is now made to FIG 2, which illustrates exemplary aspects of a schematic diagram for three-dimensionally molded electronic substrate 200. The three-dimensionally molded electronic substrate 200 comprises a three-dimensionally molded work piece 210, patterned conductive tracks 220 and an electronic module 230.

The three-dimensionally molded work piece 210 may comprise any moldable material that can withstand both the process of applying patterned conductive tracks and the process of mounting electronic modules. In particular, the moldable material may be polymeric and have a glass transition temperature greater than 150 °C. The moldable material may comprise of a composition that, upon being subjected to an activation step, enables a conductive layer to be subsequently deposited onto the activated regions. The moldable material may also comprise a surface film that comprises of a composition that, upon being subjected to an activation step, enables a conductive material to be subsequently deposited onto the activation region. The material composition for activation may comprise of a polymeric-metallic complex that undergoes a molecular transformation when activated.

The molded material may be formed into three-dimensional molded work piece 210 through injection molding, matrix molding, compression molding, blow molding, extrusion and transfer molding. The three-dimensional molded work piece 210 may comprise of connection structures 240 which facilitates mechanical connection of the three-dimensional molded work piece 210 to other mechanical surfaces such as a frame or circuit board. The three-dimensionally molded work piece 210 may also be molded to accommodate the attachment of an electronic module 230 and/or mechanical connectors to a circuit board.

The activation step may comprise a chemical process and/or an energy exposure process. The activation step may also comprise selectively activating regions of the molded material such that at least two intersecting surface planes of the three-dimensionally molded work piece 210 are exposed. Selective activation may be done through a mask that comprises regions where chemicals and/or energy radiation is allowed to interact with the moldable material's surface and regions where chemicals and/or energy radiation is prevented from interacting with the moldable material's surface. Selective activation may also occur through selective exposure from an energy radiation source. This selective exposure may be achieved through the use of an energy radiation source that may be configured to operate by moving in three-dimensions so as to expose the surfaces of a three-dimensional structure uniformly. The energy radiation source may comprise a laser that operates under the process parameters of laser direct structuring (LDS). The activated surface may be characterized by promoting and/or accepting bonding of a conductive material.

The patterned conductive tracks 220 may comprise a metallic, polymeric, or metallic/polymeric material that can be accepted by the activated surface. The patterned conductive tracks 220 may be deposited onto the exposed activated surface through a process of electro or electro-less plating. The patterned conductive tracks 220 may also be deposited onto the exposed activated surface through sputtering, evaporation, liquid dispensing, or spray coating. The deposited tracks may be continuous over two or more intersecting surface planes, thereby allowing for conduction over sidewalls. The patterned conductive tracks 220 may also form regions that may promote the creation of electronic connections, such as bonding pad 225. The patterned conductive tracks 220 may also be formed to create conductive patterns with added electronic functionality such as antenna arrays, electro-magnetic shielding grids, or strain sensors.

The electronic module 230 may comprise at least one electronic component. The electronic component may be a pressure sensitive switch, a capacitive coupling switch, a speaker, a light emitting diode (LED), an electrical I/O plug, or an image capturing device such as a charge couple device (CCD). In addition, the electronic module may comprise at least one conductive interface (such as a contact pad) that is electrically connected to the electronic component. The conductive interface enables a conductive material outside of the electronic module, to electrically contact to the electronic component.

The electronic module 230 may be mounted to the three-dimensionally molded work piece 210. The electronic module 230 may be mounted using a bonding process that enables electrical connection between the electronic module 230 and conductive track 220. The electrical connection may be provided through the conductive interface of the electronic module 230. The electrical connection may be produced through an electrical connection produced by solder, conductive glue, anisotropic conductive materials (film or paste), cold welding, or mechanical pressure. The electronic module 230 may be bonded to the three-dimensionally molded work piece 210 through the solder connection, the conductive glue connection, the anisotropic conductive material (film or paste) connection, the cold welding connection, non-conductive epoxy connections, or thermal fusing of the electronic module 230 with the surface of the three-dimensionally molded work piece 210. The electronic module 230 may be mounted to a region of the three-dimensionally molded work piece 210 that has been molded to accommodate the size and/or shape of the electronic module 230. Thus, an electronic module that has a substantially flat underside may be mounted to a single planar surface of the three-dimensionally molded work piece 210.

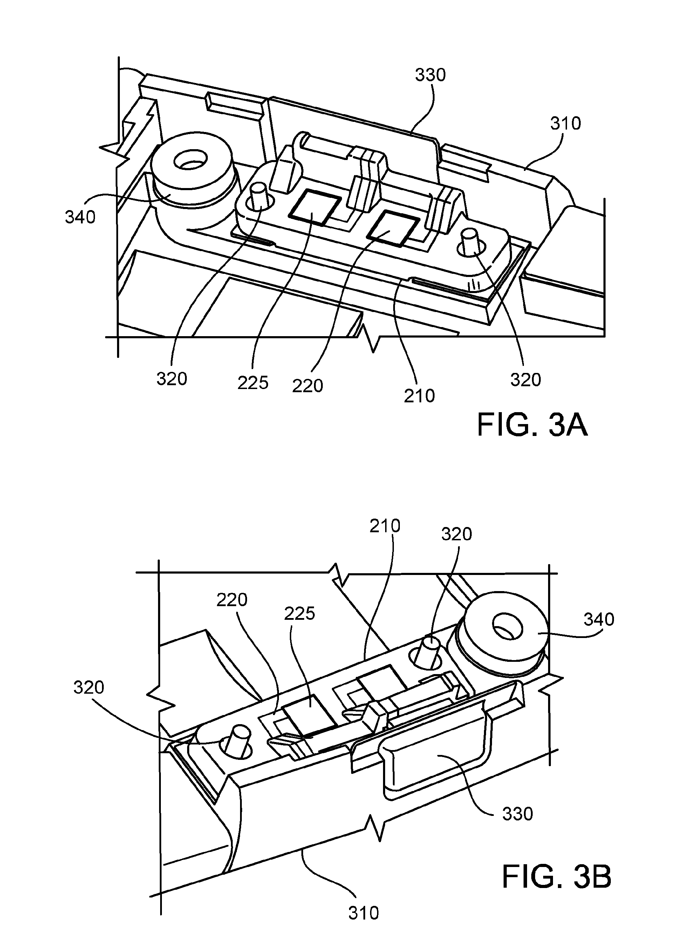

FIGS. 3A and 3B illustrate exemplary aspects of a three-dimensionally molded electronic substrate attached to a frame. The three-dimensionally molded work piece 210 of FIG. 2 is mounted to a frame 310 through mechanical connectors 320. In addition, a functional work piece 330 may be included to protect the electronic module 230 and also to add enhanced functionality and aesthetics.

The frame 310 may be molded in any number of ways. The frame 310 may, for example, comprise multiple sub-assemblies that may be assembled together to form a complete device frame. As a result, the frame 310 may consist of frame connection locations 340 which may be used to connect the frame 310 together with other frame sub-assemblies. The frame 310 may also include at least one electrically conductive track, which may be formed using any number of the same techniques as described for forming electrical tracks on the three-dimensionally molded work piece 210 in FIG 2. In addition, the frame 310 may have electronic modules connected to it in a similar manner as the electronic module 230 is connected to the three-dimensionally molded work piece 210. In addition, the frame material may comprise organic materials, inorganic materials, or a combination thereof. The frame material may also comprise of the same material composition as the three-dimensionally molded work piece 210.

The three-dimensionally molded work piece 210 may be designed to accommodate for the design of frame 310. The three-dimensionally molded work piece 210 may be mechanically connected to the frame 310 through the mechanical connector 320. The mechanical connector 320 interacts with the three-dimensionally molded work piece 210 through connection structure 240 (Fig. 2). The three-dimensionally molded work piece 210 may also be mechanically fixed to the frame 310 through any combination of solder connections, conductive glue connections, the anisotropic conductive material (film or paste) connections, cold welding connection, non-conductive epoxy connections, thermal fusing, or other mechanical connectors such as crimps, snaps or spring connections.

Functional work piece 330 may also be included and may be attached above the electronic module 230. This functional work piece 330 may include features that improve the functionality of the electronic module 230, that protect the electronic module 230 and that increase the aesthetics of the frame design. In the case where the electronic module 230 is a switch, functional work piece 330 serves a functional purpose by increasing the switch's pressure area, serves a protective purpose by sealing out the environment, and serves an aesthetic purpose through its look and feel. In other exemplary aspects, the functional work piece 330 may comprise an optical lens system, an optical diffusion system, an acoustic system and/or a sealing system.

When the frame 310 comprises conductive tracks, electrical connections may be formed between the frame's conductive tracks and conductive tracks 220 on the three-dimensionally molded work piece 210. The electrical connection may be produced through an electrical connection produced by solder, conductive glue, anisotropic conductive materials (film or paste), cold welding, or mechanical pressure.

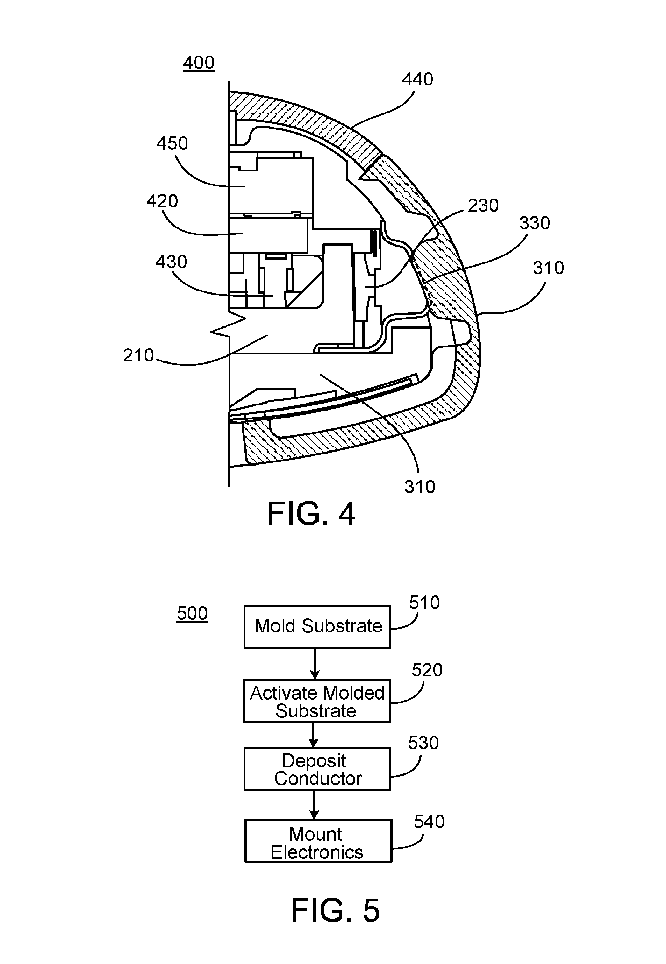

FIG 4 is an illustration of exemplary aspects of a three-dimensionally molded electronic substrate attached to the frame 310 and a circuit board 420. The three-dimensionally molded work piece 210 of FIG 2 is mounted to the frame 310. In addition, the PCB 420 is connected to the three-dimensionally molded work piece 210 through PCB connector 430. Sub-assembly frames 440, 450 and functional work piece 330 may be connected to each other and to frame 310 so as to form a completed frame assembly 400.

The circuit board 420 may comprise either a PCB or Flex system. The circuit board 420 may be electrically connected to the three-dimensionally molded work piece 210 through the connector 430. The connector 430 may comprise a universal connector, a crimp connector, a metallic spring contact or any other electrically conductive structure that operates through mechanical pressure. The connector 430 may be bonded to a contact pad 225 through solder, conductive glue, anisotropic conductive materials (film or paste), cold welding, or mechanical pressure. The circuit board 420 may also be bonded mechanically to the three-dimensionally molded work piece 210 through the solder connection, the conductive glue connection, the anisotropic conductive material (film or paste) connection, the cold welding connection, non-conductive epoxy connections, thermal fusing, mechanical forces exerted through a crimp connection or through the metallic spring contact and mechanical forces exerted through mechanical pressure from the frame 310 and sub-assembly frames 440 and 450.

The circuit board 420 may also be connected to a combination of the sub-assembly frames 440, 450 and/or the frame 310. The connection may be produced through mechanical connection locations which are designed in the sub-assembly frame 440, 450 and the frame 310 to accommodate for the circuit board 420. In addition, the circuit board 420 may be electrically connected to conductive tracks located on the sub-assembly frames 440, 450 and the frame 310. These electrical connections may be formed through a universal connector, a crimp connector, or any other electrically conductive structure, and may be bonded to the conductive tracks on the sub-assembly frames 440, 450 and the frame 310 through solder, conductive glue, anisotropic conductive materials (film or paste), cold welding, or mechanical pressure.

FIG 5 shows a flowchart for an exemplary manufacturing process 500 for fabricating a three-dimensionally molded electronic substrate. The process 500 includes molding (510) a moldable material, activating (520) the moldable material and depositing (530) a conductor/conductive material onto the molded material in the activated regions. The process 500 also includes mounting (540) an electronic module onto the molded material.

The molding 510 may form a moldable material substrate into a three dimensional structure that includes at least two intersecting surface planes. The molding may comprise the process of injection molding, matrix molding, compression molding, blow molding, extrusion and transfer molding. The molding 510 may be designed so as the molded substrate conforms to the design of a work piece such as a frame. The molding 510 may also be designed to provide the moldable material a mechanical connection means to connect to at least one other work piece.

The activating 520 of the moldable material may comprise a process for selectively activating regions of the molded substrate. The activation may provide the activated regions certain characteristics that allow for selective deposition of conductive materials to these regions. The activation may be achieved through a chemical process and/or through a process of exposure with an energy radiation source. The activation process may be made selective through the use of a masking structure that only allows the process of activation to occur in certain regions. The activation may also be made selective through the use of an activation source that is allowed to mechanically move in three-dimensions to activate the molded surface. The activation may also be made selective through the use of an activation source that stays fixed while the molded surface is allowed to mechanically move in three-dimensions around the activation source. The selective activation may provide for a continuous pattern over at least two intersecting surface planes of the three dimensional molded structure. The characteristics may allow for improved and/or selective deposition 530 of a single or set of conductive materials. The activation may occur through the process of laser direct structuring (LDS).

The depositing 530 of the conductive material onto the activated region may be achieved through depositing a conductive material that may advantageously be deposited onto the activated region. The depositing 530 of the conductive material onto the activated region may be achieved through a plating process, where the plating is conducted through electro or electroless plating. The deposition 530 may also be achieved through sputtering, evaporation, liquid dispensing, or spray coating. The deposition may also occur through a mask structure which selectively allows metal deposition onto the activated regions. The deposition of the conductive material may also comprise depositing a conductive material that comprises multiple layers of different conductive materials. The deposition of the conductive material may also comprise depositing a conductive material that comprises multiple layers of different conductive materials where the layer bonding to the substrate comprises a conductive material that may advantageously be deposited onto the activated region.

The mounting 540 of the electronic module may be achieved through electrically connecting the conductive interface of the electronic module to the selectively deposited conductive materials on the molded substrate. This mounting may be achieved through use of solder, conductive glue, anisotropic conductive materials (film or paste), cold welding, or mechanical pressure. In addition, the mounting 540 of the electronic module may be facilitated on a surface that has a similar form to the electronic module. The mounting 540 of the electronic module may also occur on a single planar surface on the molded substrate.

The disclosed implementations generally provide for an electronic device that comprises a three-dimensionally molded substrate and a patterned conductive track across the substrate's three-dimensional surface. An electronic module is mounted to the substrate's surface and electrically connected to the conductive track, thereby forming an electronic functionality in three-dimensions. The three-dimensionally molded substrate can be designed in a large number of configurations, allowing for greater design freedom in surrounding frame/housing structures than can normally be achieved from using electronic modules mounted onto PCB and Flex.

While this specification includes many specific implementation details, these should not be construed as limitations on the scope of what may be claimed, but rather as descriptions of features specific to particular implementations. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Though, particular implementations of the subject matter have been described, other implementations are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain implementations, multitasking and parallel processing may be advantageous.

## Claims

1. An electronic device configured in three dimensions, comprising:
a substrate that is molded to comprise a three dimensional structure, the three dimensional structure **characterized by** at least two intersecting surface planes, the substrate enabled to accept a conductive material;
a conductive pattern, comprising the conductive material, overlaid onto the three dimensional structure of the molded substrate such that the conductive pattern is continuous over at least two intersecting surface planes of the three dimensional structure; and
an electronic module comprising an electronic component and a conductive interface, the electronic module attached to the three dimensional structure such that the conductive interface makes electrical contact with the conductive pattern.

2. The electronic device of claim 1, wherein the three dimensional structure includes a mechanical connection location that allows for mechanical fixation of the substrate to a frame.

3. The electronic device of claim 1, wherein the overlaid conductive pattern is formed through plating.

4. The electronic device of claim 1, wherein the electronic component comprises one of a switch, a speaker, a light emitting diode, a plug, and an image capturing device.

5. The electronic device of claim 1, wherein the electronic module is attached to a single plane of the three dimensional structure.

6. The electronic device of claim 1, wherein the substrate is enabled to be used in a laser direct structuring (LDS) process.

7. An electronic system configured in three dimensions, comprising:
a frame;
a substrate mechanically connected to the frame, the substrate comprising:
a three dimensional structure, the three dimensional structure **characterized by** at least two intersecting surface planes, the substrate enabled to accept a conductive material;
a conductive pattern, comprising the conductive material, overlaid onto the three dimensional structure of the molded substrate such that the conductive pattern is continuous over two intersecting surface planes of the three dimensional structure; and
an electronic module comprising an electronic component and a conductive interface, the electronic module attached to the three dimensional structure such that the conductive interface makes electrical contact with the conductive pattern; and
a circuit board, electrically connected to the conductive pattern on the sub strate.

8. The electronic system of claim 8, wherein the frame includes at least one mechanical connection structure configured to accommodate a mechanical connection.

9. The electronic system of claim 9, wherein the three dimensional structure includes a mechanical receiving location that allows for mechanical fixation of the substrate to the frame through the at least one mechanical connection structure.

10. The electronic system of claim 8, wherein the overlaid conductive pattern is formed through plating.

11. The electronic system of claim 8, wherein the electronic component comprises one of a switch, a speaker, a light emitting diode, a plug, and an image capturing device.

12. The electronic system of claim 8, wherein the electronic module is attached to a single plane of the three dimensional structure.

13. The electronic system of claim 8, wherein the substrate is enabled to be used in a laser direct structuring (LDS) process.

14. The electronic system of claim 8, wherein the circuit board comprises a metallic spring contact that is configured to make an electrical contact with the conductive pattern through mechanical pressure applied by the spring.

15. A manufacturing process comprising:
molding a substrate to include a three dimensional structure, the three dimensional structure **characterized by** at least two intersecting surface planes, the surface of the substrate enabled to be activated through exposure to an energy radiation source;
activating the molded substrate in a selective region with an energy radiation source such that the selectively activated region is continuous over two intersecting surface planes of the three dimensional structure;
depositing a conductive material onto the selectively activated region on the surface of the molded substrate; and
electrically mounting an electronic module to the three dimensional structure of the molded substrate, the electronic module comprising an electronic component and a conductive interface, the electronic module attached to the three dimensional structure such that the conductive interface makes electrical contact with the conductive pattern.

## Amended claims

### Amended claims in accordance with Rule 137(2) EPC.

**1.** An electronic device configured in three dimensions, comprising:
a substrate (200) that is molded to comprise a three dimensional structure (210), the three dimensional structure **characterized by** at least two intersecting surface planes, the substrate enabled to accept a conductive material, the substrate configured to form a mechanical connection to a circuit boad (420) the circuit boad configured with a conductive track;
a conductive pattern (220), comprising the conductive material, overlaid onto the three dimensional structure of the molded substrate such that the conductive pattern is continuous over at least two intersecting surface planes of the three dimensional structure, the conductive pattern configured to form an electrical connection (225) to the conductive track of the circuit board at a single surface plane of the three dimensional structure; and
an electronic module (230) comprising an electronic component and a conductive interface, the electronic module attached to the three dimensional structure such that the conductive interface makes electrical contact with the conductive pattern.

**2.** The electronic device of claim 1, wherein the three dimensional structure includes a mechanical connection location (240) that allows for mechanical fixation of the substrate to a frame (310).

**3.** The electronic device of claim 1, wherein the overlaid conductive pattern is formed through plating.

**4.** The electronic device of claim 1, wherein the electronic component comprises one of a switch, a speaker, a light emitting diode, a plug, and an image capturing device.

**5.** The electronic device of claim 1, wherein the electronic module is attached to a single plane of the three dimensional structure.

**6.** The electronic device of claim 1, wherein the substrate is enabled to be used in a laser direct structuring (LDS) process.

**7.** An electronic system configured in three dimensions, comprising:
a frame (310);
a substrate mechanically connected to the frame, the substrate comprising:
a three dimensional structure (210), the three dimensional structure **characterized by** at least two intersecting surface planes, the substrate enabled to accept a conductive material, the substrate configured to form a mechanical connection to a circuit board (420);
a conductive pattern (220), comprising the conductive material, overlaid onto the three dimensional structure of the molded substrate such that the conductive pattern is continuous over two intersecting surface planes of the three dimensional structure, the conductive pattern configured to form an electrical connection (225) to a conductive track on the circuit board at a single surface plane of the three dimensional structure; and
an electronic module (230) comprising an electronic component and a conductive interface, the electronic module attached to the three dimensional structure such that the conductive interface makes electrical contact with the conductive pattern; and
the circuit board configured with the conductive track, the conductive track being electrically connected to the conductive pattern on the substrate.

**8.** The electronic system of claim 8, wherein the frame includes at least one mechanical connection structure (320) configured to accommodate a mechanical connection.

**9.** The electronic system of claim 9, wherein the three dimensional structure includes a mechanical receiving location (240) that allows for mechanical fixation of the substrate to the frame through the at least one mechanical connection structure.

**10.** The electronic system of claim 8, wherein the overlaid conductive pattern is formed through plating.

**11.** The electronic system of claim 8, wherein the electronic component comprises one of a switch, a speaker, a light emitting diode, a plug, and an image capturing device.

**12.** The electronic system of claim 8, wherein the electronic module is attached to a single plane of the three dimensional structure.

**13.** The electronic system of claim 8, wherein the substrate is enabled to be used in a laser direct structuring (LDS) process.

**14.** The electronic system of claim 8, wherein the circuit board comprises a metallic spring contact (430) that is configured to make an electrical contact with the conductive pattern through mechanical pressure applied by the spring.

**15.** A manufacturing process comprising:
molding (510) a substrate to include a three dimensional structure, the three dimensional structure **characterized by** at least two intersecting surface planes, the surface of the substrate enabled to be activated through exposure to an energy radiation source, the substrate configured to form a mechanical connection to a circuit board configured with a conductive track;
activating (520) the molded substrate in a selective region with an energy radiation source such that the selectively activated region is continuous over two intersecting surface planes of the three dimensional structure;
depositing (530) a conductive material onto the selectively activated region on the surface of the molded substrate, to form a conductive pattern, the conductive pattern configured to form an electrical connection to a conductive track on the circuit board at a single surface plane of the three dimensional structure; and
electrically mounting an electronic module to the three dimensional structure of the molded substrate, the electronic module comprising an electronic component and a conductive interface, the electronic module attached to the three dimensional structure such that the conductive interface makes electrical contact with the conductive pattern.
